# EUROPEAN PATENT APPLICATION

(11) **EP 2 806 468 A1**
(43) Date of publication of application: **26.11.2014**
(21) Application number: 13382191.8
(22) Date of filing: 24.05.2013
(51) Int. Cl.: H01L 31/052, H01L 31/05

(54) **Photovoltaic receiver for solar concentrator**

(71) Applicant: Universidad Politécnica de Madrid, 28040 Madrid (ES)
(72) Inventor: Anton Hernandez, Ignacio, E-28031 Madrid (ES); Sala Pano, Gabriel, E-28040 Madrid (ES); Victoria Perez, Marta, E-28040 Madrid (ES); Askins, Stephens, E-28040 Madrid (ES); Dominguez Dominguez, César, 38300 Bourgoin-Jallieu (FR)
(74) Representative: ABG Patentes, S.L.

(57) **Abstract**

The present invention relates to a solar cell receiver, formed as a support for said solar cell, suitable for reflective solar concentrator modules. Another object of the invention is the solar module comprising a plurality of these solar receivers. The reflective solar concentrator modules place the solar cell between the energy source, the Sun, and the reflective surface. The present invention is characterized by a special configuration of a solar cell receiver that allows linking a plurality of said solar cells in series, resolving the problems of shade and manufacturing difficulties existing in the state of the art. It further allows extending a plurality of solar cells according to a directrix allowing directional changes.

## Description

### Object of the Invention

The present invention relates to a solar cell receiver, formed as a support for said solar cell, suitable for reflective solar concentrator modules. Another object of the invention is the solar module comprising a plurality of these solar receivers.

The reflective solar concentrator modules place the solar cell between the energy source, the Sun, and the reflective surface.

Reflective solar concentrator modules are usually made up of a closed cavity where the base is formed by a plurality of reflective mirrors the focal of which point coincides with or is close to the position of the transparent cover assuring the closure of the module.

The limited space between the plurality of mirrors and the transparent cover is filled with a fluid that preferably has the same refractive index as the transparent cover. When a fluid of these characteristics is used, the inner surfaces of the transparent cover are no longer interfaces having different refractive indexes, and they therefore become transparent, reducing the number of reflections of light inside the module.

When manufacturing such modules, the position of the solar cell inside the module must be assured so that it coincides with the focus of the corresponding reflective surface, the solar cells must be electrically connected with the exterior to enable extracting the generated energy, and casting excessive shade on the reflective surface must be avoided so as to not reduce module efficiency.

The present invention is characterized by a special configuration of a solar cell receiver that allows linking a plurality of said solar cells in series, solving the problems indicated, and further allows extending a plurality of solar cells according to a directrix allowing directional changes.

### Background of the Invention

One of the fields of the art that has experienced extensive development is the solar energy field. Photovoltaic concentration consists of using optical elements for concentrating light on high-efficiency solar cells. This allows simultaneously obtaining very high-efficiency systems at a reasonable cost because by concentrating the light, the necessary size of the solar cell is smaller, and therefore its cost is also lower.

One of the known solutions that allows concentrating solar radiation on high-efficiency cells are reflective solar concentrator modules. These modules are formed by a plurality of mirrors that are covered with a transparent cover. There is a side closure between both elements that keeps both the reflective surfaces and the solar cells collecting the radiation concentrated by the reflective surfaces therein isolated.

The reflective surfaces are of a reduced size so that they are cheaper to manufacture. In contrast, the manufacture of a specific collection area will have a high number of reflective surfaces and of solar cells, and furthermore the area of the solar cell is not insignificant with respect to the reflective area. This last point is very important because the solar cell always casts shade on the reflective surface. The fixing of the solar cell in the transparent cover and the connection of a plurality of solar cells in series means that the shade that is cast is larger and the manufacture is very expensive.

The present invention solves these problems of the state of the art by means of a receiver with a particular structure that allows attaching the solar cells in series, giving rise to the electrical connection between the solar cells arranged in series and offering a minimum shade area.

Another advantage offered by this technical solution is the possibility of automating the manufacture, for example by means of robots, equipping all the solar cells in a module with supports and electrical connection, and allowing the cells arranged in series to be extended according to a directrix that shows directional changes.

### Description of the Invention

A first aspect of the invention is a solar cell receiver suitable for reflective solar concentrator modules. These reflective solar concentrator modules have a transparent cover and the module internally has a plurality of concave mirrors with the focal point located in the transparent cover, at the point where the solar cell is placed. They are preferably internally filled with a fluid with a refractive index close to the refractive index of the transparent material of the cover to prevent the existence of interfaces with refractive index changes, and therefore the inner surfaces of the cover are no longer surfaces that generate reflections.

The solar cells in these modules are usually located on the inner surface of the transparent cover and oriented towards the corresponding concave mirror.

The solar cell receiver according to the first inventive aspect comprises:
*a main body made up of an electrically conductive material extending along a directrix X-X', where this main body comprises:*
   - *a side extension giving rise to a support on which there is located a semiconductor configured for operating like a solar cell capable of generating a potential between the surface resting on the conductive support and the opposite free surface suitable for receiving the light,*
   - *a first longitudinal prolongation according to directrix X-X*',
   - *a second longitudinal prolongation according to directrix X-X' extending in the direction opposite the first prolongation, where this second prolongation has a dielectric with a housing suitable for receiving and housing at least part of the first prolongation of another solar cell receiver and where this second prolongation also has a second side extension.*

The receiver according to the invention is formed by a main conductive body intended for supporting a solar cell. This receiver has a special configuration that allows consecutively arranging a plurality of such receivers in series. The receiver must be able to place the solar cell at the focal point of the corresponding mirror, cast minimum shade on the same mirror, and establish suitable electrical communication to be able to extract the generated energy out of the module.

The configuration provided by a body that extends longitudinally according to a first prolongation and a second prolongation allows consecutively linking two receivers, leaving the solar cell in an intermediate region. Given that said solar cell is located in a side extension, the body of the receiver does not interfere in the light transmitted or in the light reflected and concentrated in the solar cell. In other words, the main body is not necessarily located along the axis of symmetry of the mirror.

This configuration also allows manufacture by die-cutting and subsequent bending, which are operations that can be automated, obtaining more than one receiver per operation of the machine performing the die-cutting and bending.

Consecutive receivers are linked by means of a dielectric. This dielectric is attached to the second prolongation and has a housing receiving the first prolongation of the consecutively arranged receiver. The relative position between solar cells is thereby assured while at the same time short circuits between solar cells arranged in series are prevented.

When the housing is calibrated, it is possible that the mere assembly between receivers will determine the distance between solar cells, making manufacturing easier. An example of calibration is the incorporation of projections or ports both in the dielectric and in the second prolongation of the consecutively arranged receiver such that they are coupled in only one specific position. An exact relative position is thereby assured.

It is also possible for the housing to allow a specific relative movement between receivers according to the longitudinal direction. This solution allows correcting relative positioning errors. Both solutions will be appropriate depending on the method of manufacturing the module.

The position of the semiconductor on the side extension means that said side extension acts as a support and is furthermore electrically communicated with one of the surfaces of the semiconductor. Illumination of the semiconductor generates a potential difference giving rise to the generation of electric energy. The other surface of the conductor, i.e., the surface intended for being illuminated, can be easily accessed by means of a conducting wire.

*It is verified that the solar cell receiver is configured to allow configuring a plurality of receivers arranged in series, given that once they are located in series it is verified that:*
- *the housing of the dielectric of a receiver receives the first prolongation of the following consecutive receiver,*
- *the second side extension is arranged close to the side extension giving rise to a support on which there is located the semiconductor configured for operating like a solar cell of the following receiver, and spaced from said support so as to not come into electrical contact therewith,*
- *this same second side extension allows the electrical connection with the free upper surface of the semiconductor configured for operating like a solar cell for example by means of welding conducting wire.*

The mechanical attachment between receivers is achieved as a result of the dielectric. The dielectric is linked to the second prolongation and has a housing that receives the first prolongation of the following receiver. Given that the structural link is by means of the dielectric, the second prolongation is electrically insulated from the first prolongation of the consecutive receiver.

This consecutive attachment furthermore assures the electrical attachment in series between the solar cells located between the consecutively arranged receivers. This is possible because the second side extension of the consecutive receiver is located in the proximity of the solar cell, which is located in a side extension, without coming into contact with it. An electrical connection is established between the second side extension and the surface of the solar cell intended for being illuminated, which is what gives rise to an arrangement in series between the solar cells.

Another object of the invention is the solar module comprising a plurality of receivers for supporting the solar cells as well as a solar power plant formed by a plurality of solar modules.

### Description of the Drawings

These and other features and advantages of the invention will be more clearly understood from the following detailed description of a preferred embodiment, given only as an illustrative and non-limiting example in reference to the attached drawings.
Figure 1 shows a perspective view of an embodiment of the invention.
Figure 2 shows a perspective view of two embodiments like the one shown in the preceding figure arranged consecutively to show the mutual coupling mode.
Figure 3 shows a second embodiment with a configuration that allows directional changes between two consecutive receivers.
Figure 4 shows the inner surface of a transparent cover of a reflective solar concentrator module on which a plurality of receivers is located with their solar cells connected in series.
Figure 5 shows a plan view of an embodiment of a reflective solar concentrator module. This same plan view shows the position of a section according to line F-F.
Figure 6 shows the section according to a plane of section extending in the direction indicated in the preceding figure and shown with reference F-F.

### Detailed Description of the Invention

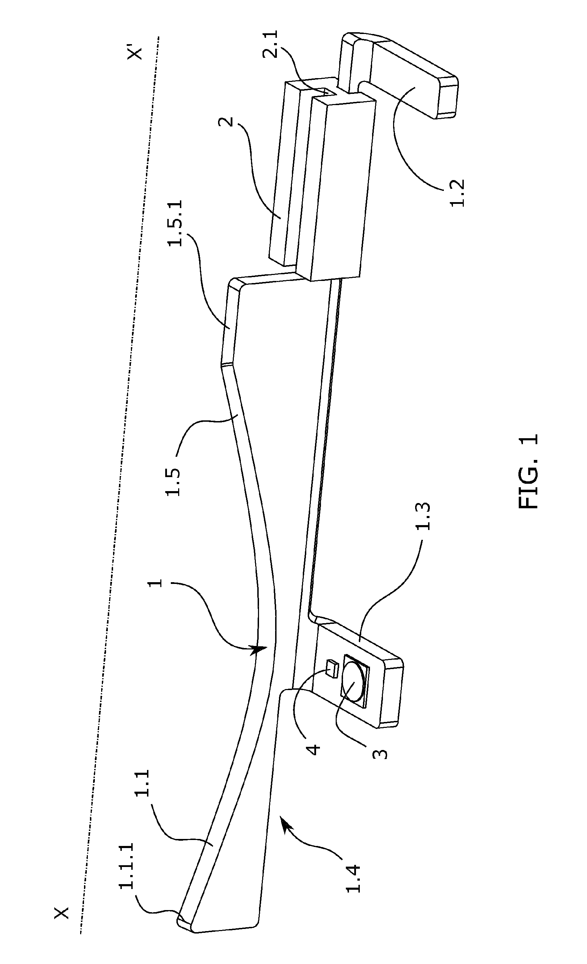

According to the first inventive aspect, the present invention relates to a solar cell receiver suitable for reflective solar concentrator modules. Figure 1 shows a first embodiment of the invention according to a perspective view.

Said Figure 1 shows a receiver formed by a main body (1) extending along a directrix X-X'. In this embodiment, the main body (1) is formed from a conductive metal plate shaped by means of die-cutting and bending operations.

By using the orientation shown in the drawings, the main body (1) extends to the left in a first prolongation (1.1), following the direction of directrix X-X', and to the right in a second prolongation (1.5), also following the direction of directrix X-X' but in the direction opposite the first prolongation (1.1).

A support (1.3) configured as a side extension of the main body (1) is shown between both prolongations (1.1, 1.5). In this particular case the side extension has been obtained by means of bending the plate forming the main body (1) 90°. This support (1.3) has a dual function, the lower surface not seen in Figure 1 acts as a support base against the surface of the transparent cover (9) of the module where it is installed, being able to be attached by means of adhesive, for example. The other function is to support a solar cell (3). This solar cell (3) is formed by a semiconductor which generates a potential between the surface which is in contact with the support (1.3) and its free upper surface, i.e., the surface intended for being illuminated, when it is illuminated. The surface in contact with the support (1.3) causes the entire main body (1) made up of a conductive material to have the same potential as the lower base of the solar cell (3).

The second prolongation (1.5) extended at its end in a second side extension (1.2) is shown on the right side of the drawing. This second side extension is parallel to the first side extension giving rise to the support (1.3) and furthermore extends laterally towards the same side of the main body (1). In this embodiment, the second side extension (1.2) has also been obtained by means of an operation of bending the plate forming the main body (1) 90°.

The first prolongation (1.1) shows a notch (1.4) in the lower part. The lower part of the second prolongation (1.5) is located at a specific height with respect to the base of the support (1.3) intended for resting on the surface of the transparent cover (9), and as a result of the existence of the notch (1.4) the first prolongation (1.1) has a greater height than the second prolongation (1.5).

At the end of the second prolongation (1.5) there is a dielectric (2) with a housing (2.1) which is in the form of a channel in this example. The greater height of the lower part of the first prolongation (1.1) due to the existence of the notch (1.4) coincides with the height of the base of the channel of the housing (2.1) of the dielectric (2).

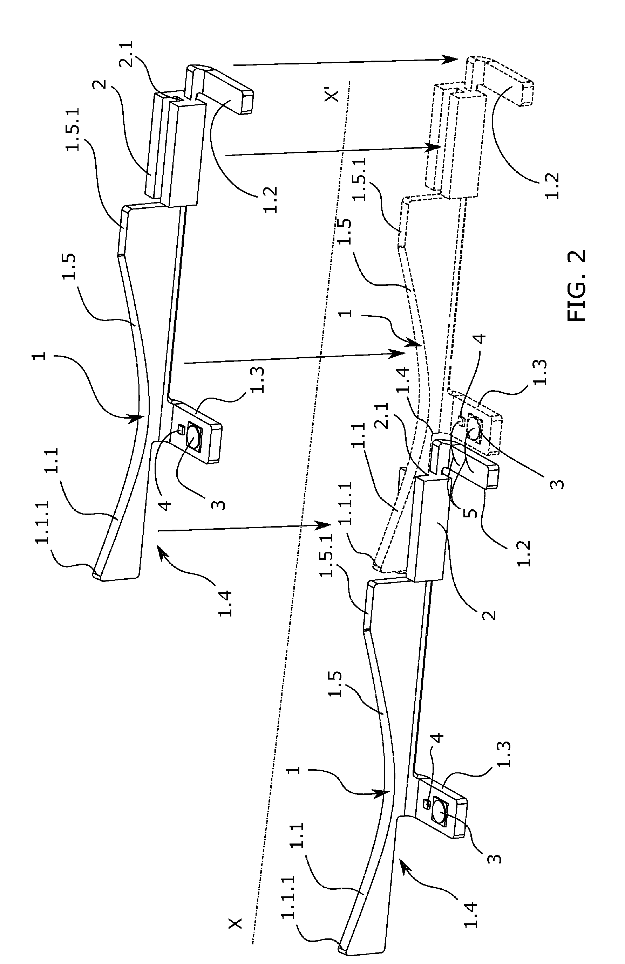

As shown in Figure 2, by means of this configuration, a second receiver with the same configuration arranged consecutively with respect to first receiver places its first prolongation (1.1) in the channel-shaped housing (2.1) of the dielectric (2) of the first receiver.

Figure 2 shows the second receiver in a raised position and an insertion direction indicated by means of four parallel arrows leading to the final position indicated by means of dotted lines.

Once both receivers are attached through the dielectric (2), no electrical communication is observed between the main body (1) of the first receiver and the main body (1) of the second receiver. The dielectric (2) is placed between both main bodies (1)

Furthermore, the parallel position between the first side extension giving rise to the support (1.3) and the second side extension (1.2) in one and the same main body (1) results in these same side extensions (1.2, 1.3) between consecutive receivers having a close parallel arrangement, but without being in contact with one another.

This close position allows electrically communicating the second side extension (1.2) of the first receiver not with the first main body (1) of the second receiver but with the upper surface of the solar cell (3) located in the support (1.3) of the second receiver by means of an electrical connection (5). This configuration means that between the main body (1) of the first receiver and the main body (2) of the second receiver there is a potential difference equal to the potential difference established between the lower surface and upper surface of the solar cell (3) of the second receiver.

A diode (4) also with its base located on the support (1.3) and electrically communicated with the support and with the only free surface by means of an electrical connection with the second side extension (1.2) of the first receiver is shown next to each solar cell (3). This diode (4) favors the flow of current therethrough when the solar cell (3) is not being illuminated or receives less illumination than the solar cells (3) of other receivers connected in series. This diode (4) acts by preventing the solar cell (3) from acting like a resistive load when any of the indicated situations arises because it could heat up excessively and be destroyed.

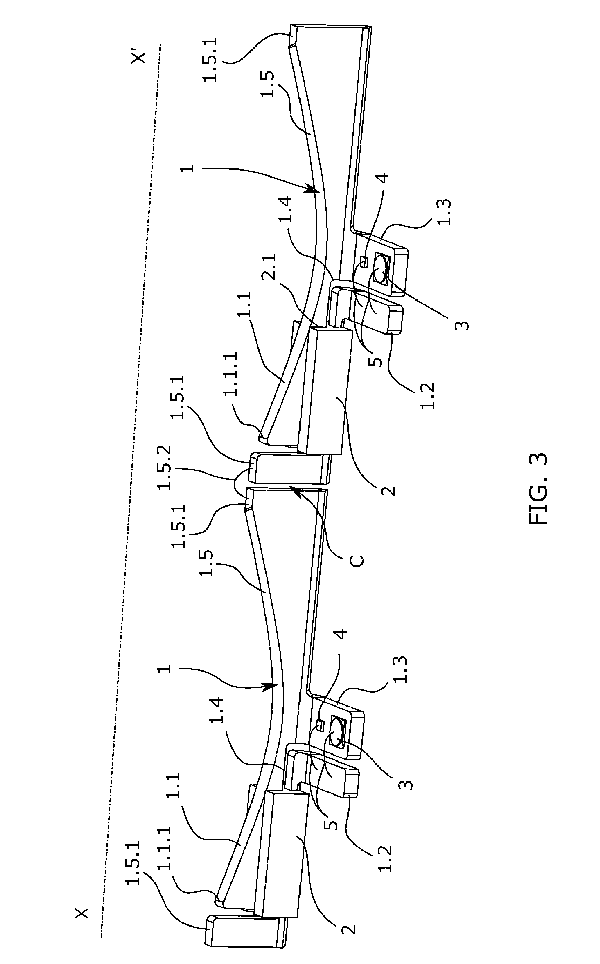

Figure 3 shows a second embodiment where the second prolongation (1.5) is sectioned (C) but both parts (1.5.1) located on both sides of the section (C) are electrically communicated by means of a conductive element (1.5.2). In this embodiment, the conductive element (1.5.2) is a conducting wire welded at its ends to both parts (1.5.1) located on both sides of the section (C).

Without the section (C), a rigid main body that extends longitudinally extends along a straight directrix X-X'. A receiver according to this second embodiment allows directional changes in the spot where the section (C) is located. In this embodiment, the section (C) is located in the second prolongation (1.5).

A combination of the first embodiment and the second embodiment allows distributing a set of solar cells (3) on the inner surface of the transparent cover (9) of a reflective solar concentrator module.

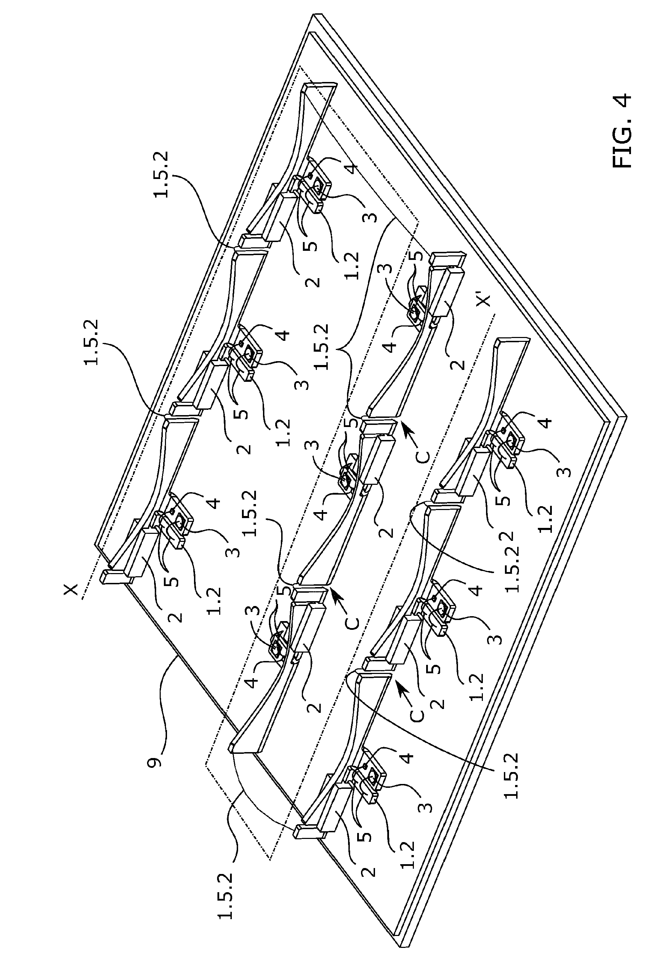

Figure 4 shows a plurality of receivers according to the second embodiment. A total of nine receivers with their solar cells (3) located on the transparent cover (9) of a module, occupying the positions corresponding to the focus of nine mirrors or reflective surfaces (S) when the transparent cover (9) closes the module in the operative mode, are shown.

The nine receivers are arranged in series establishing a path of directrix X-X' in a zigzag configuration, with a distribution of three rows of three receivers each. In each row the conductive element (1.5.2) maintaining the electrical connection between the parts (1.5.1) located on both sides of the section (C) is not used to achieve a directional change. However between rows, the length of the conductor (1.5.2) is such that it maintains the electrical connection between spaced parallel paths.

The electrical connection (5) linking the free upper surface of each solar cell (3) with the second side extension (1.2) of the consecutive receiver means that the potential generated in each solar cell (3) establishes a potential difference between consecutive main bodies (1). The result is that the potential difference between the first receiver and the last receiver is the sum of the potential increments supplied by all the solar cells (3).

The main body (1) of the first receiver and the main body (1) of the last receiver are electrically connected with the output terminals of the module to extract the energy generated by the plurality of solar cells (3).

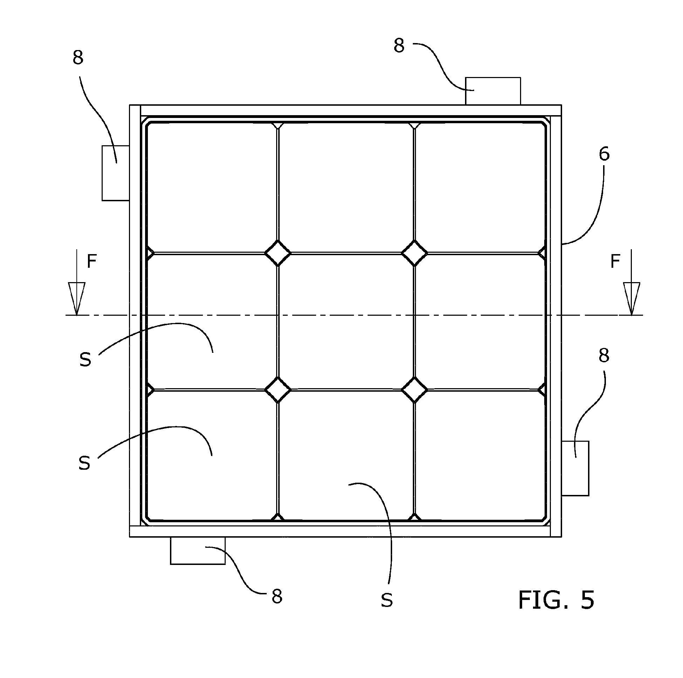

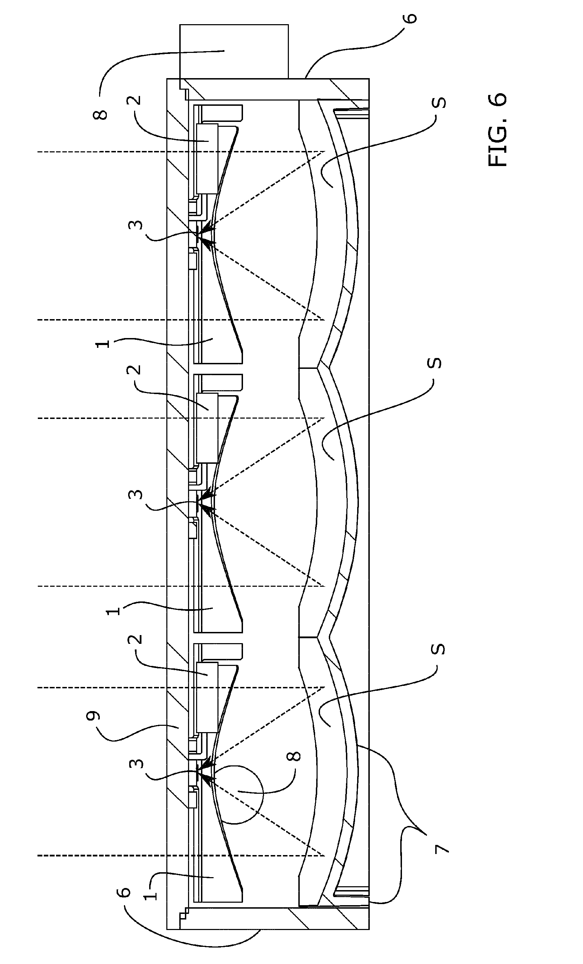

Said Figure 4 shows the stepped perimetral edge of the transparent cover (9). This step fits into the side closure of the module as shown in Figure 6, the section identified according to plane of section F-F of the module shown in Figure 5.

The receivers with the solar cells (3) located on the surface of the transparent cover (9) of Figure 4 are located on the inner face of said transparent cover (9). In Figure 4, the cover (9) is oriented with the inner face looking upwards in order to clearly show the placement of the plurality of receivers.

In Figure 6, the transparent cover (9) is in the operative mode, the solar cells being oriented downwards, always following the orientation shown in the drawings, i.e., oriented such that the solar cells (3) are oriented with their free surface oriented towards the reflective surfaces (S). The reflective surfaces (S) form the base of the module. In this embodiment, the reflective surfaces (S) are injection-manufactured in one part (7) that fits into the lower part of the base of the module. The side body (6) of the module has a perimetral wall configuration receiving the part (7) with the reflective surfaces in the lower portion. The part (7) with the reflective surfaces (S), the side body (6) of the module and the transparent cover (9) therefore define a closed inner chamber protecting both the reflective surfaces (S) and the solar cells (3) from the elements.

Dotted lines ending in an arrow indicate the path of the light beams coming from the Sun. These beams go through the transparent cover (9), the inner space of the module and reach the reflective surface (S). The light beams reaching the reflective surface (S) are reflected in a convergent manner towards the focus where the solar cell (3) is located. Since the receivers that supported the solar cells (3) have a planar configuration essentially parallel to the path of the light beams, they cast virtually no shade on the reflective surface (S), only the thickness of the main body (1) and the side extensions which are necessary for placing the solar cell (3) such that it is suitably oriented for receiving the concentrated light beams intervene.

The described module is manufactured in transparent plastic. In this embodiment, the space of the closed inner chamber of the module is filled with a fluid with a refractive index that is essentially equal to the refractive index of the transparent cover (9). The inner surface of the cover (9) therefore does not establish an interface between two media having a different refractive index, and therefore the reflections and refractions that would be generated, reducing module efficiency, are eliminated. The effect of this fluid is "to make the inner surface of the cover of the module visually disappear".

Likewise, in this embodiment the dielectrics (2) assuring the attachment between receivers are also manufactured in a plastic having a refractive index essentially equal to the refractive index of the fluid filling the inner space of the module and to the refractive index of the transparent cover (9).

In this embodiment, as shown in Figures 5 and 6, the module has input and output connections (8) providing fluid communication of the inside of the module with the exterior. These connections (8) allow circulating the inner fluid to successfully cool the solar cells (3). These connections (8) simultaneously allow the exit of the conductive current contacts out of the module.

It is also noted that the shape of the main body of the receivers shown in the section of Figure 4 adopts a narrowing in the region of the solar cell and widens towards the ends. In particular, the narrowing is due to the arch configuration of the edge of the main body (1). The solar cell (3) is located in a support (1.3) formed by means of a first side extension of the main body (1). This side extension extends towards one of the sides. The narrowing reduces possible interferences with light beams passing close to the solar cell (3), mainly the beams coming from the half of the reflective surface (S) corresponding to the opposite side towards where the support (1.3) of the solar cell (3) extends.

Additionally, the broader region of the ends increases the area of contact with the fluid that is inside the module, favoring heat transfer between the main body (1) and the surrounding fluid to in turn favor cooling the solar cell (3).

Said Figure 5 shows a plan view of the square configuration of the module, being able to configure panels by connecting several modules covering a specific area.

The module, the panel thus built and the power generation plant using these modules are objects of this invention.

## Claims

1. A solar cell receiver suitable for reflective solar concentrator modules of the type made up of a transparent cover (9), wherein the module internally has a plurality of concave mirrors with the focal point located in the transparent cover (9), preferably being filled with a fluid with a refractive index close to the refractive index of the transparent material of the cover (9); and having solar cells preferably located on the inner surface of the transparent cover (9), oriented towards the corresponding concave mirror; where said solar cell receiver comprises:
a main body (1) made up of an electrically conductive material extending along a directrix X-X', where this main body (1) comprises:
- a side extension giving rise to a support (1.3) on which there is located a semiconductor configured for operating like a solar cell (3) capable of generating a potential between the surface resting on the conductive support (1.3) and the opposite free surface suitable for receiving light,
- a first longitudinal prolongation (1.1) according to directrix X-X',
- a second longitudinal prolongation (1.5) according to directrix X-X' extending in the direction opposite the first prolongation (1.1), where this second prolongation (1.5) has a dielectric (2) with a housing (2.1) suitable for receiving and housing at least part of the first prolongation (1.1) of another solar cell receiver and where this second prolongation (1.5) also has a second side extension (1.2),
where it is further verified that the solar cell receiver is configured to allow configuring a plurality of receivers arranged in series, given that once they are located in series it is verified that:
- the housing (2.1) of the dielectric (2) of a receiver receives the first prolongation (1.1) of the following consecutive receiver,
- the second side extension (1.2) is arranged close to the side extension giving rise to a support (1.3) on which there is located the semiconductor configured for operating like a solar cell (3) of the following receiver, and spaced from said support (1.3) so as to not come into electrical contact therewith,
- this same second side extension (1.2) allows the electrical connection (5) with the free upper surface of the semiconductor configured for operating like a solar cell (3) for example by means of welding conducting wire.

2. The solar cell receiver according to claim 1, **characterized in that** the side extension giving rise to a support (1.3) on which there is located a semiconductor configured for operating like a solar cell (3) also comprises a protective diode (4) that is electrically connectable with the second side extension (1.2) of the consecutive solar cell receiver, the diode (4) and the semiconductor configured for operating like a solar cell (3) being in parallel to favor the flow of current through the diode (4) when the solar cell is not being illuminated or receives less illumination than the cells of other receivers connected in series.

3. The solar cell receiver according to claims 1 and 2, **characterized in that** the longitudinal main body (1) according to directrix X-X' is sectioned (C) such that the parts on both sides of the section (1.5.1) are electrically communicated by means of a conductive element (1.5.2), preferably a conducting wire, to allow directional and positional changes in directrix X-X'.

4. The solar cell receiver according to any of the preceding claims, **characterized in that** the main body (1) is shaped by die-cutting and bending a conductive plate such that:
- the first longitudinal prolongation (1.1) according to directrix X-X',
- the second longitudinal prolongation (1.5) according to directrix X-X',
- the support (1.3) and
- the second side extension (1.2), are configured as part of a die-cut plate where both the support (1.3) and the second side extension (1.2) emerge laterally as a result of a bend.

5. The solar cell receiver according to claim 4, **characterized in that** the first longitudinal prolongation (1.1) according to directrix X-X' has a notch (1.4) suitable for housing at least part of the second longitudinal prolongation (1.5) of the consecutive receiver.

6. The solar cell receiver according to claim 4 or 5, **characterized in that** the support (1.3) and the second side extension (1.2) are configured according to flat bars arranged parallel to one another when two or more solar cell receivers are arranged consecutively.

7. The solar cell receiver according to any of claims 4 to 6, **characterized in that** the surface of the support (1.3) opposite the surface where the semiconductor configured for operating like a solar cell (3) is located is suitable for being adhered to the transparent cover (9) of a closed solar concentrator module.

8. The solar cell receiver according to any of the preceding claims, **characterized in that** the dielectric is made of plastic with a refractive index close to the refractive index of the fluid with which the module where it is intended to be housed is filled.

9. A closed concentrator module comprising:
- an inner cavity closed by a transparent cover (9), where inside the inner cavity there is a plurality of concave reflective mirrors (S) with the focal point located on the inner surface of the transparent cover (9),
- a plurality of solar cell receivers according to any of claims 1 to 8 attached to the transparent cover (9) and connected in series such that:
o each semiconductor configured for operating like a solar cell (3) located on a support (1.3) is at the focal point of one of the concave mirrors (S) and is oriented towards said concave mirror (S),
o directrix X-X' of the plurality of solar cell receivers attached in series establishes a path taken by the plurality of focal points of the concave mirrors (S),
o the ends of the plurality of solar cell receivers attached in series are electrically communicated with the terminals of the module.

10. The module according to claim 9, **characterized in that** it comprises a fluid with a refractive index close to the refractive index of the transparent material of the cover (9) filling the inner cavity.

11. The module according to claim 9, **characterized in that** at least two of the consecutively arranged solar cell receivers are attached by the dielectric (2) resulting from a molding operation.

12. The closed concentrator module according to claim 9, **characterized in that** it comprises a fluid input connection and a fluid output connection to allow circulating and cooling the inner fluid.

13. A solar concentrator panel comprising a plurality of closed concentrator modules according to any of claims 9 to 12.

14. A solar energy collection power plant comprising at least one solar concentrator panel according to claim 13.
